# EUROPEAN PATENT SPECIFICATION

(11) **EP 4 451 417 B1**
(45) Date of publication and mention of the grant of the patent: **27.08.2025**
(21) Application number: 23168911.8
(22) Date of filing: 20.04.2023
(51) Int. Cl.: H01M 10/42, H01M 10/48, H01M 50/284, H01M 50/503, H01M 50/519, H01M 50/521, H01M 50/522, H01M 50/524, H01M 50/526, H01M 50/529, H01M 50/569, H01M 50/581

(54) **ELECTRICAL INTERCONNECT BOARD FOR A BATTERY MODULE WITH INTEGRATED TEMPERATURE MEASUREMENT CAPABILITIES**
ELEKTRISCHE VERBINDUNGSPLATTE FÜR EIN BATTERIEMODUL MIT INTEGRIERTEN TEMPERATURMESSFÄHIGKEITEN
CARTE D'INTERCONNEXION ÉLECTRIQUE POUR MODULE DE BATTERIE À CAPACITÉS DE MESURE DE TEMPÉRATURE INTÉGRÉES

(43) Date of publication of application: 23.10.2024
(73) Proprietor: Airbus S.A.S., 31700 Blagnac (FR)
(72) Inventor: FRIEDBERGER, Alois, 31700 Blagnac (FR); KÜHN, Lars, 31700 Blagnac (FR); FRIEDL, Stephan, 31700 Blagnac (FR)
(74) Representative: LKGLOBAL Lorenz & Kopf Patentanwalt Attorney at Law PartG mbB

(56) References cited:
- WO-A1-2019/164974
- CN-A- 114 919 457
- US-A1- 2017 054 128
- US-A1- 2023 107 112

## Description

### TECHNICAL FIELD

The present disclosure relates to an electrical interconnect board for a battery module. In particular, the disclosure relates to an electrical interconnect board having integrated temperature measurement capabilities for single battery cells of a battery module and to a battery module including such an electrical interconnect board.

### TECHNICAL BACKGROUND

Temperature generally has one of the highest impacts on electronics lifetime. Further, battery modules are manufactured from a plurality of battery cells that are usually interconnected with each other in a combined serial and parallel connection matrix. In particular in case of thermal runaway conditions of single battery cells, early detection of such conditions is important to be able to take counter measures in order to avoid damaging the battery module and the electronics of it.

For such temperature measurements, usually dedicated temperature sensors are used that either need to be wired (e.g., by means of cables) or, e.g., in PCB (printed circuit board) applications, such sensors (or rather parts of such sensor systems) need to be soldered on the PCB. To enable early detection of overheating conditions such as thermal runaway condition, ideally temperature measurements of each individual battery cell is to be implemented. This, however, is particularly challenging because of the considerable wiring effort. This wiring effort and the huge amount of connection points are a root cause for measurement faults and the reliability and the mean time between failure of the measurement system is impacted by such implementations.

Further, in case of wired sensors inside power electronics applications or batteries, the insulation coordination is impacted by the wires, and if the wires are distributed across the system, problems with regard to arc tracing may occur. This is the case in state-of-the-art battery systems. Additionally, soldering or wiring of dedicated sensors has an impact on production cost, because sensors must be produced or procured and there are additional steps necessary in the set-up of the connections. Also, in particular in aircraft applications, weight reduction generally is one of the main constraints in designing any system for the aircraft. Because of these reasons, in case of battery systems, usually just some sensors (e.g., 50 sensors) are used, and individual cell temperature monitoring (requiring usually, e.g., up to 2000 sensors or more) is not possible.

Patent application CN 114 919 457 A relates to an improved power battery system for a vehicle, which is capable of responding to a plurality of temperature signals in the battery module when thermal runaway or thermal escape occurs in the cells of the battery module.

### DESCRIPTION

It is an objective to provide an electrical interconnect board for a battery module having integrated individual temperature measurement capabilities for individual battery cells.

This objective is solved by the subject matter of the independent claims. Further embodiments are described in the dependent claims as well as in the following description.

According to a first aspect, an electrical interconnect board with integrated cell temperature measurement for a battery module having a plurality of battery cells is provided. The electrical interconnect board comprises a printed circuit board and a readout device. The printed circuit board comprises an insulating layer, a first electrically conductive layer, and a second electrically conductive layer. The first electrically conductive layer and the second electrically conductive layer are arranged on opposite sides of the insulating layer. The printed circuit board comprises a plurality of receptacles each configured for accommodating a corresponding battery cell of the battery module. The first electrically conductive layer is configured to electrically interconnect the plurality of battery cells with each other. The first electrically conductive layer and the second electrically conductive layer are made from different electrically conductive materials. The first electrically conductive layer and the second electrically conductive layer are connected with each other through the insulating layer at a plurality of locations by a plurality of vertical interconnect accesses (VIAs). Each VIA builds a thermoelectric interface and thereby forms an integrated thermal sensor element that generates a voltage depending on the temperature at the thermoelectric interface. The readout device senses the generated voltages of the VIAs and determines corresponding temperature values.

In general, a printed circuit board (PCB; also printed wiring board or PWB) is a medium used in electrical and electronic engineering to connect electronic components to one another in a controlled manner. It takes the form of a laminated sandwich structure of conductive and insulating layers. Each of the conductive layers is designed with an artwork pattern of conductive tracks (or traces), planes and other features (similar to wires on a flat surface), e.g., etched from one or more sheet layers of an electrically conductive material (oftentimes copper) laminated onto and/or between sheet layers of a non-conductive substrate. Electrical components may be fixed to conductive pads on the outer layers in the shape designed to accept the component's terminals, generally by means of soldering, to both electrically connect and mechanically fasten them to it.

Such PCBs may, however, also be used to interconnect individual battery cells of a battery module with each other. According to the disclosure, for this purpose the PCB has a plurality of receptacles which are designed to accommodate the individual battery cells and connect them with each other in a predefined electrical circuit, e.g., in a matrix of serial and parallel connections. For the interconnection of the individual cells, the first electrically conductive layer may be structured/designed to achieve the desired interconnection pattern of the individual battery cells and in particular has corresponding connection points, such as the contact elements described further below, that are configured to contact the electrodes of the battery cells. For example, receptacles for battery cells that are arranged in a line in one of the extension directions of the PCB may be interconnected with each other in a serial connection, while each of such line may be interconnected in a parallel connection. However, any other connection scheme is possible, too.

The receptacles may, e.g., be corresponding cut-outs or recesses in the insulating layer sized to accommodate the individual battery cells, while the first electrically conductive layer is shaped to interconnect these battery cells with each other, when they are placed in the receptacles. The first electrically conductive layer may, e.g., be a non-uniform layer, such as in a regular PCB, where the conductive tracks are routed to each of the receptacles to provide corresponding connection points, i.e., terminals, for the battery cells.

To provide integrated temperature measurement capabilities, the PCB further comprises the second electrically conductive layer. The second conductive layer in general is separated from the first conductive layer by the insulating layer.

The disclosed electrical interconnect board utilizes the thermoelectric effect ("Seebeck effect", also sometimes referred to as the "Peltier-Seebeck effect") to provide temperature measurement at certain positions/locations of the electrical interconnect board (in particular near the locations of the receptacles and therefore near the locations of individual battery cells, when the battery cells are connected by the electrical interconnect board).

In general, thermoelectricity is the relationship between temperature gradient and electrical voltage along an electrical conductor. This relationship is different for each conductor material. In an open circuit consisting of two different conductor materials, there is a difference between these internal voltages, which is accessible externally at the free ends as a thermoelectric voltage. In a closed circuit, the thermoelectric voltage generates an electric current and thus directly electrical energy, which is taken from the thermal energy in the junction points between the materials. The relationship between the temperature and voltage is described by so called Seebeck coefficients of the materials involved. These Seebeck coefficients are material constants of the respective materials. If the Seebeck coefficients of the involved materials are different, the Seebeck effect, as described above, occurs.

Therefore, the first electrically conductive layer and the second electrically conductive layer are made from different electrically conductive materials (in particular materials having different Seebeck coefficients) and are connected with each other through so called vertical interconnect accesses (VIAs). In other words: the VIAs provide through plating junctions between the first electrically conductive layer and the second electrically conductive layer. That is, the first electrically conductive layer and the second electrically conductive layer comprise corresponding conductive tracks which are connected with each other through the VIAs. The respective conductive tracks on the other hand are connected to the readout device. Since the first electrically conductive layer and the second electrically conductive layer (i.e., the conductive tracks of these layers) are made from different (electrically conductive) materials, these junctions can be used as an integrated temperature sensor (thermocouple or thermoelement) by analyzing the difference of the electrical potentials of the corresponding tracks of the first electrically conductive layer and of the second electrically conductive layer (i.e., the thermoelectrically created voltage). For this, the readout device is configured to measure the voltage and to determine a temperature value corresponding to the measured voltage based on the known Seebeck coefficients of the material of the first electrically conductive material and of the second electrically conductive material. In principle, such thermocouples may be located at any position on the PCB. Therefore, individual battery cell temperature monitoring of each battery cell interconnected by the electrical interconnect board can be achieved by providing a corresponding VIA near every receptacle for a battery cell. However, corresponding VIAs may also be located near only some of the receptacles.

Although described as connecting the first electrically conductive layer (which, as described further above, also acts as electrical interconnection layer for the battery cells) and the second electrically conductive layer, it should be appreciated that the PCB may also comprise a third (or even more) electrically conductive layer, that is isolated form the other electrically conductive layers, for example, by one or more additional insulating layers. The thermocouples may then also be created by interconnecting, for example, the second electrically conductive layer and the third electrically conductive layer by corresponding VIAs, such that the second electrically conductive layer and the third electrically conductive layer act purely as thermocouple layers. In such configurations, too, at least the layers participating in the thermoelectric effect (i.e., the second and third electrically conductive layers) are made from different electrically conductive materials, in particular from materials having different Seebeck coefficients, such that a temperature difference at the junctions (at the VIAs) causes a voltage drop at the corresponding conductive tracks of the layers.

Overall, the number of sensors is just limited by the size of the PCB and the sensor electronics. Therefore, high resolution temperature maps may be measured for a battery module utilizing the electrical interconnect board. Therefore, in particular, early detection of thermal runaway conditions of individual battery cells is possible. This allows to shutdown the battery system / battery module before a critical cell temperature can emerge. Such conditions may, for example, occur if an individual battery cell reaches a higher temperature than others due to poor manufacturing quality, or if the cooling in the area of one or some battery cells is not functional. Variations among battery cells may also occur in heavily aged cells, which is why some battery cells may reach higher temperatures than others.

Instead of dedicated temperature sensor parts (e.g., SMD sensors, based on different technologies) which need to be soldered or wired, the disclosed thermal sensor elements (implemented by the VIAs) is built directly as part of the PCB by adding an additional conductive layer and through plating elements (VIAs).

The readout device may be any device or arrangement of devices suitable for analyzing the corresponding signals from the corresponding VIAs. The readout device may, e.g., be an arrangement of microchips on the PCB, wherein each microchip is associated with specific VIAs for analyzing their signals. However, the readout device may also be a device external to the PCB, such as a general-purpose computer having a CPU and corresponding memory components and programming for analyzing the signals. In such configurations, the conductive tracks of the first and second electrically conductive layers corresponding to the VIAs may be routed to an externally accessible terminal of the PCB which may be connected to the external computer or device. Such a terminal may also be present when using dedicated microchips to control and read out these microchip by an external device, such as a computer.

In this case, corresponding conductive tracks from the microchips may be routed to the externally accessible terminal.

The disclosed electrical interconnect board offers high availability for multi sensor applications, such as individual battery cell temperature monitoring. In particular, the implementation is very cost efficient and no additional production time for the implementation is necessary. Further, the sensor principle is also applicable for laminated bus bars. In this case, however, VIAs would not necessarily have to be used as sensors, although they also could. Since in laminated bus bars, foils are laminated, an additional degree of freedom arises. Such foils can have different blanks. In laminated bus bars, tongues or tabs made of the two different materials lying on top of each other can be guided up to above the battery cells, and the welding point of both of these tongues/tabs on one electrical terminal of the battery cells forms the contact and thus also the temperature sensor in the same way as the described VIAs do. Manufacturing of the discloses electrical interconnect board is very similar to the manufacturing of regular PCBs. The disclosed sensor principle therefore not only is applicable for the disclosed electrical interconnect board but also with any PCB. For both, PCBs and laminated bus bars, a standard insulation coordination process is applicable. The defined process and the utilized implementation of the connection between sensors and sensor electronics (readout device) is much safer than the implementation of wired sensors. Also, since dedicated temperature sensors (e.g., sensor elements soldered onto the PCB) are avoided, weight of the overall battery module can be greatly reduced. Because of the enhanced safety, reliability, cost-efficiency, and the reduced weight, the disclosed electrical interconnect board enables an individual battery cell temperature monitoring for battery modules.

According to an embodiment, the plurality of receptacles are corresponding recesses in the printed circuit board. The first electrically conductive layer protrudes into each of the plurality of recesses, thereby building contact elements configured to contact electrodes of a corresponding one of the battery cells, such that the battery cells of the battery module are electrically connected to each other to build an electrical circuit of battery cells.

Such recesses may, for example, be corresponding cut-outs in the PCB, especially in the insulating layer. The first electrically conductive layer may then protrude into these recesses, for example, in the form of contact tabs or other contact elements (i.e., terminals) which are part of first electrically conductive layer. These contact elements may be interconnected with each other by corresponding conductive tracks of the first electrically conductive layer, such that the desired circuitry between the contact elements (i.e., between the battery cells, when the electrical interconnect board is in use) is established. In particular, two such contact elements may be present for each recess, such that a positive and a negative terminal for the corresponding battery cell is provided.

The recesses and the contact elements are formed accordingly to support and connect the desired design battery cell type. If the design battery cell type is a cylindrical cell, the recess may be cylindrical, if the design battery cell type is a rectangular cell, the recess may be rectangular, and so on. The contact elements protrude into these recesses, such that they can contact the terminals of the corresponding battery cell type. The battery cells may be constructed such that both, the positive and the negative terminals, are accessible from one side of the battery cell. For example, in cylindrical battery cells, the negative terminal (which usually is arranged opposite the positive terminal) may be electrically connected to the cylindrical housing of the battery cell, such that the negative terminal may be contacted at an edge of the side of the battery cell where the positive terminal is located. In this way, both terminals of a battery cell may be contacted by the contact elements of the electrical interconnect board from the same side of the battery cell. The desired circuitry may then be achieved by appropriately designing the conductive tracks of the first electrically conductive layer.

According to another embodiment, the first electrically conductive layer is made from copper.

Copper is a common material for PCBs comprising excellent electrical conductivity.

According to another embodiment, the second electrically conductive layer is made from a copper-nickel alloy.

Such a copper-nickel alloy can be easily joined to the copper material of the first electrically conductive material and, in combination with copper, exhibits the Seebeck effect described above.

According to another embodiment, the second electrically conductive layer is made from constantan.

Constantan is a copper-nickel alloy usually consisting of 55 % copper and 45 % nickel. However, other compositions are possible, too. The material of the second conductive material may, for example, comprise 50 % copper and 50 % nickel, 60 % copper and 40 % nickel, 65 % copper and 35 % nickel, or any other composition of copper and nickel.

Constantan together with copper builds a standardized thermal element / thermocouple which is referenced as a T type thermocouple. The physical properties of such a thermocouple are well understood. Since constantan is copper based, a constantan layer can be processed in the same way as a copper layer to build conductive tracks to connect the thermal sensor elements (formed by the VIAs) with the readout device. Therefore, VIAs between a copper layer and a constantan layer can be produced in a common production process for PCB. Therefore, a combination of a copper layer as the first electrically conductive layer and a constantan layer as the second electrically conductive layer is preferred because it allows for a relatively simple production process.

According to another embodiment, the location of each VIA is located near a corresponding contact element of an associated recess, such that the thermal sensor element formed by the corresponding VIA measures a temperature near the location of the corresponding contact element.

By arranging each VIA near a corresponding contact element, the thermal sensor element formed by the VIA measures the temperature in the direct neighborhood of the corresponding battery cell and gives an indication of the temperature of the battery cell itself.

According to another embodiment, the corresponding contact element is configured to conduct heat from an associated battery cell to the corresponding VIA, such that the thermal sensor element formed by the corresponding VIA indicates a temperature of the associated battery cell.

The contact elements are in direct contact to the terminals of the battery cells when connected by the electrical interconnect board. Since the contact elements are made from an electrically conductive material, they also provide at least some thermal conductivity. Therefore, heat from the battery cells, such as when one of the battery cells exhibits a thermal runaway condition, is conducted from the battery cell to the corresponding VIA. Since heat from the battery cell is conducted to the VIA, the temperature measured by the thermoelectric effect at the VIA substantially corresponds to the temperature of the battery cell itself. Preferably, the material of the first electrically conductive layer comprises large heat transfer capabilities.

According to another embodiment, the contact elements of each recess comprise a positive contact element configured to contact a positive electrode of the battery cell and a negative contact element configured to contact a negative electrode of the battery cell.

According to another embodiment, at least one of the positive contact element and the negative contact element is split into a connection section and a sensor section.

Since the contact elements within each recesses act as terminal elements for battery cells, the contact elements conduct electrical current. Because of the electrical resistance of the contact elements, the current flow through the contact elements therefore lead to an increase in temperature of the contact element. The corresponding heat may be transferred to the corresponding VIAs and therefore may influences or falsify the temperature measurement results. In order to avoid this, the contact elements, which are associated with the corresponding thermal sensor elements (VIAs) may be split into two distinct parts or sections: a connection section and a sensor section. The sensor section serves only to conduct heat from the battery cells to the corresponding VIA and does not conduct any electrical current from the corresponding battery module. For this, the sensor section is connected to the corresponding VIA. The connection section is isolated from the corresponding VIA and only serves to conduct electrical current from the associated battery cell. In other words: the sensor sections conduct only heat from the battery cell to the thermal sensor element to sense the temperature of the corresponding battery cell while the connection sections electrically interconnect the individual battery cells with each other.

According to another embodiment, the sensor section and the connection section are electrically and/or thermally isolated from each other.

For this, for example the sensor section and the connection section may, for example, be isolated from each other by providing an air gap between the connection section and the sensor section. This air gap may, e.g., be provided by etching during the PCB production process or by laser cutting afterwards. Optionally, the air gap may be filled with an electrically and thermally isolating material, such as a corresponding resin or other insulating material.

According to another embodiment, the connection section is configured for electrically connecting and thereby integrating the battery cell into the electrical circuit of battery cells.

According to another embodiment, the sensor section is associated with a corresponding VIA and configured to conduct thermal energy of the battery cell to the corresponding VIA.

According to another embodiment, the readout device comprises at least one sensor chip. A conductive track of the first electrically conductive layer and a conductive track of the second electrically conductive layer that are associated with a corresponding VIA are connected to a corresponding one of the sensor chips, such that the corresponding sensor chip is configured to measure a voltage between the corresponding conductive tracks of the first electrically conductive layer and of the second electrically conductive layer and to determine a corresponding temperature value based on the measured voltage.

The sensor chips may, for example, be accordingly configured microchips which measure the voltage at each corresponding VIA and to determine an associated temperature at the corresponding VIA (as described above) and therefore at the corresponding battery cell, when the electrical interconnect board is used to interconnect the battery cells to build a battery module. Each sensor chip may also be associated to multiple VIAs or each sensor chip may be associated to a single VIA. Further, the sensor chips itself may be connected with a superordinate control device, such as a computer having a display device or any other suitable device, to allow a user to display and/or process the measured temperature values.

According to another embodiment, the electrical interconnect board further comprises at least one dedicated reference temperature sensor arranged in the vicinity of the at least one sensor chip.

Since an additional connection between the conductive tracks from the corresponding VIA to the sensor chip is necessary, a further thermocouple between different materials may exist that influences the overall measured voltage. A dedicated reference temperature sensor may therefore be present near each of the sensor chips, such that the temperature near the corresponding sensor chip may be determined by the reference temperature sensor. By using the detected temperature value from the reference temperature sensor near the sensor chip, the sensor chip may calculate the effect of the second thermocouple out of the determined temperature value.

According to a second aspect, a battery module is provided. The battery module comprises a plurality of battery cells and an electrical interconnect board of any one of the embodiments described above. Each of the plurality of battery cells is arranged within a corresponding one of the receptacles, such that the battery cells are connected with each other to form a circuit of battery cells.

The electrical interconnect board may be configured according to any one of the embodiments described herein. Therefore, each feature described with regard to the electrical interconnect board is equally applicable for the battery module.

In summary, the present disclosure provides an electrical interconnect board for a battery module and a corresponding battery module comprising such electrical interconnect board with integrated temperature measurement capabilities that do not rely on wired or soldered temperature sensors. Rather, the described electrical interconnect board comprises inherently integrated thermal sensor element in the form of VIAs in a printed circuit board. Therefore, wiring effort and connection points are greatly reduced and temperature measurement of single battery cells of a battery module can be implemented.

Although the present disclosure is described with regard to battery module applications, it should be appreciated that the disclosed measuring principle is equally applicable for any electronic component relying on temperature measurements at defined locations.

### BRIEF DESCRIOPTION OF THE DRAWINGS

In the following, exemplary embodiments are described in more detail having regard to the attached figures. The illustrations are schematic and not to scale. Identical reference signs refer to identical or similar elements. The figures show:
- **Fig. 1**: A schematic perspective view of an electrical interconnect board with integrated single cell temperature measurement capabilities for cylindrical battery cells in a battery module.
- **Fig. 2**: A schematic top view and a perspective view of a receptacle of the electrical interconnect board of Fig. 1.
- **Fig. 3**: A schematic top view and a perspective view of a receptacle of the interconnect board of Fig. 1 having connect elements that are split in a connection section and in a sensor section.
- **Fig. 4**: A schematic cross sectional view of a receptacle of an interconnect board illustrating possible lay ups of a printed circuit board of the electrical interconnect board.
- **Fig. 5**: A schematic top view of an interconnect board for a battery module illustrating routing and connecting of the integrated thermal sensor elements implemented by vertical interconnect accesses (VIAs) to corresponding sensor chips.
- **Fig. 6**: A schematic view of a battery module having a plurality of battery cells that are interconnected with the disclosed electrical interconnect board.

### DETAILLED DESCRIPTION

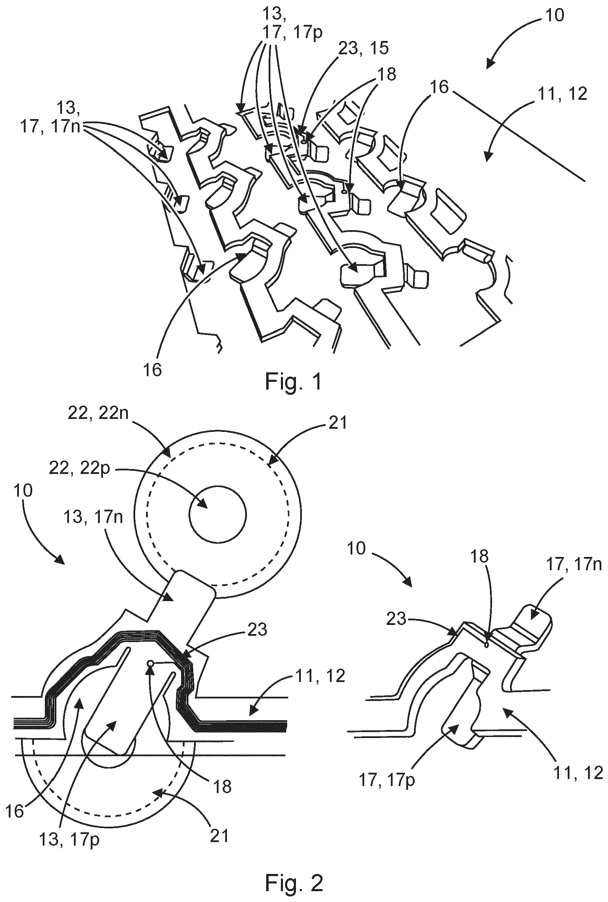

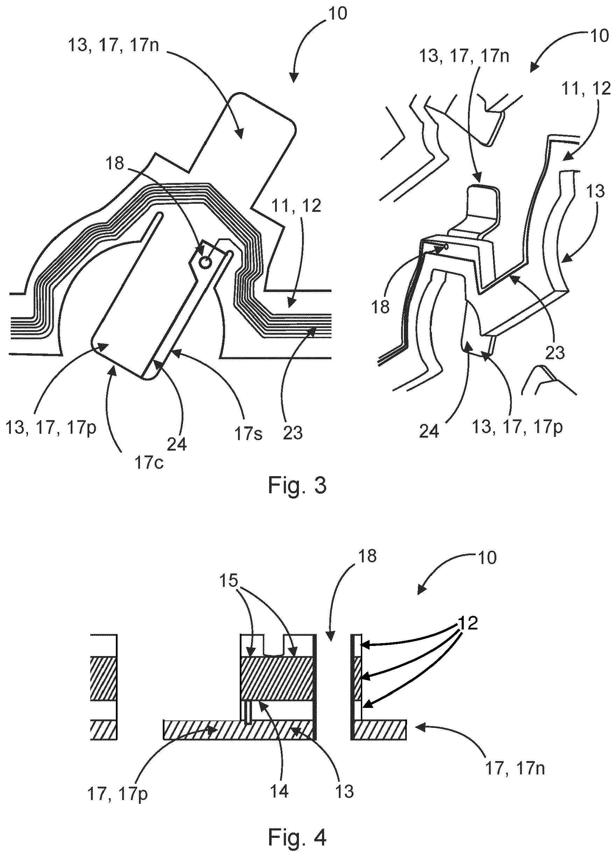

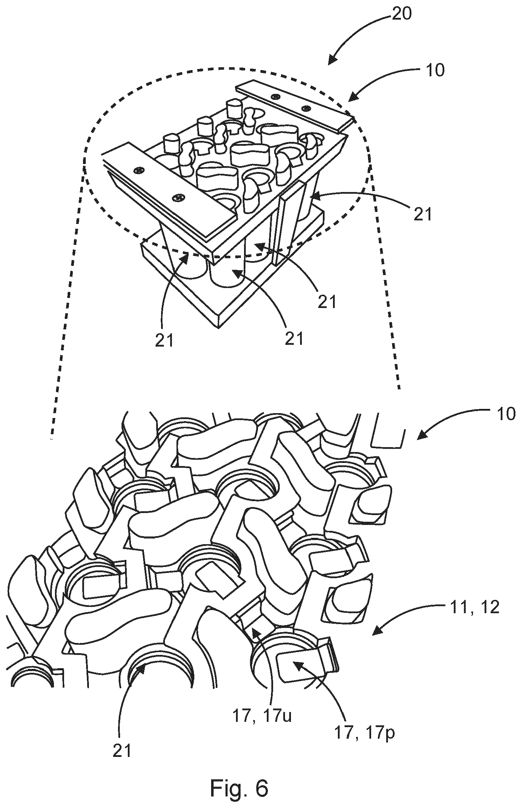

Fig. 1 schematically shows an electrical interconnect board 10 with integrated cell temperature measurement for a battery module 20 (not shown in Fig. 1, see, Fig. 6). The electrical interconnect board 10 comprises a printed circuit board (PCB) 11 having an insulating layer 12, a first electrically conductive layer 13 and a second electrically conductive layer 14 (not explicitly shown in Fig. 1, see cross section in Fig. 4). The insulating layer 12 comprises a plurality of receptacles 16 (two indicated by reference signs) in the form of recesses 16 (or cut outs) in the insulating layer that are shaped to accommodate individual battery cells 21 (see Fig. 2 and 6). The first electrically conductive layer 13 is arranged on a bottom side of the PCB 11 and comprises a plurality of contact elements 17 for contacting electrodes 22 (see Fig. 2) of battery cells 21. The contact elements 17 are distinguished in positive contact elements 17p and negative contact elements 17n. The positive contact elements 17p are configured to contact a positive electrode 22p (Fig. 2) of a battery cell 21. The negative contact elements 22n (Fig. 2) are configured to contact a negative electrode 22n of a battery cell 21. Although shown as being configured for cylindrical battery cells 21, it should be appreciated that the receptacles/recesses 16 and the contact elements 17 may also be configured to accommodate any other kind of battery cell 21, such as pouch cells, rectangular cells, etc.

A plurality of vertical interconnect accesses (VIAs) 18 are shown in Fig. 1. Such VIAs 18 extend in a vertical direction through the PCB 11 and interconnect the first electrically conductive layer 13 with the second electrically conductive layer 14.

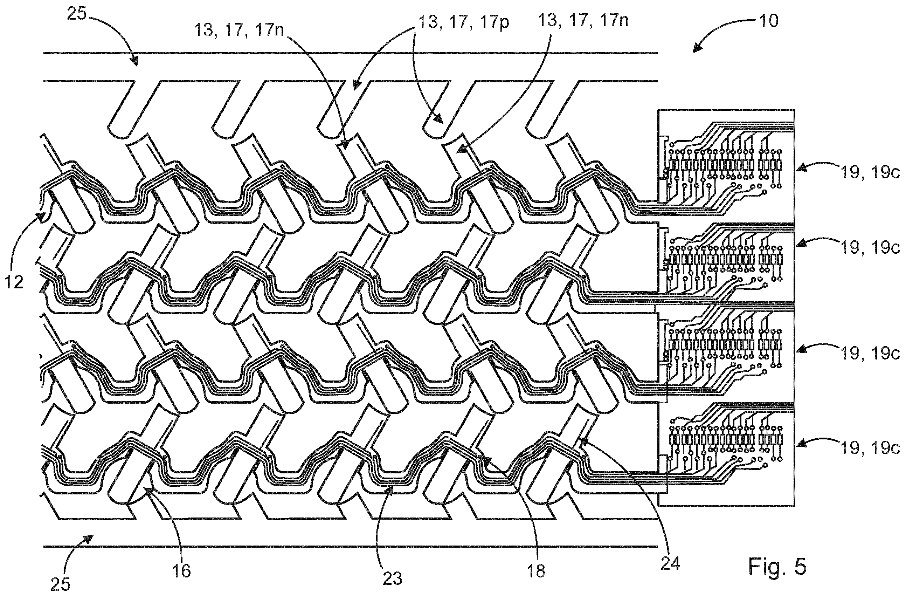

The first electrically conductive layer 13 and the second electrically conductive layer 14 are made from different electrically conductive materials, in particular from materials having different Seebeck coefficients, as described further above, such that a thermocouple (a junction between different materials experiencing a thermoelectric effect) is formed. For example, the first electrically conductive layer 13 may be made from copper and the second electrically conductive layer 14 may be made from a copper-nickel alloy, such as constantan. However, other suitable material combinations are possible, too. The VIAs 18, interconnecting the different materials of the first electrically conductive layer 13 and the second electrically conductive layer 14, act as such thermocouples (i.e., thermal sensor elements). The VIAs 18 (or rather at the junction of the different materials within the VIAs 18) generate a voltage depending on the temperature at the corresponding junction. This voltage is routed by means of conductive tracks 23 to at least one readout device 19 (see Fig. 5). The readout device 19 may then analyze the voltage and determine a corresponding temperature based on the known material constants of the different electrically conductive layers 13, 14.

In the shown configuration of Fig. 1, the second electrically conductive layer 14 is an inner layer of the PCB 11 and on top of the insulating layer 12, an additional electrically conductive layer 15 having conductive tracks 23 is arranged, which is connected through the VIAs 18 with the first electrically conductive layer 13 and only acts as signal routing layer to a readout device 19 (Fig. 5). However, the second electrically conductive layer 14 may also be arranged directly on the top side of the insulating layer 12. In general, any arrangement of electrically conductive layers providing an interface between electrically conductive materials having different Seebeck coefficients is possible.

Fig. 2 shows a schematic top view (on the left side) and schematic perspective view (on the right side) of one of the receptacles/recesses 16 of Fig. 1. In Fig. 2, the signal routing by means of conductive tracks 23 form the different VIAs 18 associated with the receptacles 18 is clearly visible. Further, in Fig. 2, two cylindrical battery cells 21 with electrodes 22, in particular each with a positive electrode 22p and a negative electrode 22n, are schematically illustrated. The negative electrode 22n is provided at a circumferential region of the cylindrical battery cells 21 and on the same side in the longitudinal direction of the battery cell 21 as the positive electrode 22p. For example, the negative electrode 22n (which, in cylindrical cells, is usually arranged on the opposite side in the longitudinal direction as the positive electrode 22p) can be routed to the circumferential region at the longitudinal side of the positive electrode 22p via an electrically conductive shell of the battery cell 21. In this way, the interconnection of all battery cells 21 can be achieved within the substantially plane electrical interconnect board. As can be seen, the positive contact element 17p and the negative contact element 17n of the first electrically conductive layer 13 interconnect the two battery cells 21 shown in Fig. 1 in a serial connection.

One of the plurality of VIAs 18 is shown in Fig. 2 as being arranged on the positive contact element 17p of the first electrically conductive layer 13. The VIA 18 thereby acts as thermal sensor element, as described above. The contact elements 17, in addition to the function as establishing the electrical interconnection of the individual battery cells 21 with each other, conduct heat from the battery cells 21 to the VIA 18 and therefore to the thermocouple, as described above, which is why the temperature measured at the thermocouple is indicative of the temperature of the battery cell 21.

It should be appreciated that the VIAs 18 may also be arranged on the negative contact element 17n. This may be even more advantageous, because the negative contact elements 17n directly contact the circumferential regions of the cylindrical battery cells 21, which is in direct contact with the enclosure of the battery cells 21. Therefore, especially in situations with fast temperature increases (such as in thermal runaway conditions), fast detection of the temperature increase is possible because the heat is almost immediately transferred to the thermocouple build by the VIA 18.

Fig. 3 shows an alternative configuration of the electrical interconnect board 10. This configuration differs from the configuration in Fig. 2 in that the contact element 17 containing the VIA 18 is split into a connection section 17c and a sensor section 17s by an air gap 24. The air gap 24 may be filled with an electrically and thermally isolating material. The air gap 24 may, for example, be achieved during the manufacturing process of the PCB 11, e.g., by etching, or afterwards, e.g., by laser cutting. However, other manufacturing methods are possible, too. The splitting into the sections 17c, 17s has the advantage, that heat flux to the VIA 18 caused by the current flow between the individual battery cells 21 is avoided. Therefore, the heat transferred to the VIA 18 (i.e., the thermocouple within the VIA 18) is "real" heat from the battery cell 21 associated with the VIA 18. The temperature indicated by the thermocouple therefore more precisely reflects the temperature of the corresponding battery cell 21.

Fig. 4 shows a cross sectional view of one of the receptacles 16 of the electrical interconnect board 10 of Figs. 1 to 3 illustrating a possible lay-up. The PCB 11 comprises a first electrically conductive layer 13, a second electrically conductive layer 14 and third and fourth electrically conductive layers 15 (n-th electrically conductive layers 15).

It should be noted that the n-th electrically conductive layers 15 are optional. A minimal lay-up would also work with just the first electrically conductive layer 13 and the second electrically conductive layer 14. In this case, corresponding conductive tracks 23 that provide the corresponding signal routings to the readout device 19, 19c (not shown in Fig. 4, see Fig. 5) would be present in each of the first and the second electrically conductive layers 13, 14.

Each of the electrically conductive layers 13, 14, 15 is isolated from each other by an insulating layer 12. A vertical interconnect access (VIA) 18 reaches through the PCB 11 and electrically interconnects each of the layers 13, 14, 15 with each other. The first electrically conductive layer 13 comprises contact elements 17, such as the positive contact element 17p and the negative contact element 17n, that reach or protrude into the receptacles or recesses 16. In particular, the positive contact element 17p and the negative contact element 17n reach into neighboring receptacles 16, such that the positive contact element 17p and the negative contact element 17n connect battery cells 21 inserted into these receptacles in a serial manner. The receptacles 16 are configured to accommodate a battery cell 21, as described above.

The first electrically conductive layer 13 and the second electrically conductive layer 14 are made from different electrically conductive materials, in particular from electrically conductive materials comprising different Seebeck coefficients. For example, the first electrically conductive layer 13 may be made from copper and the second electrically conductive layer may be made from a copper-nickel alloy, such as constantan. However, any other suitable material combination is conceivable, too. The VIA 18 may be made from the same material as the first electrically conductive layer 13. Therefore, at the junction between the second electrically conductive layer 14 and The VIA 18 (and therefore between the first and the second electrically conductive layers 13, 14), a thermocouple is built, such that the VIA 18 acts as a thermal sensor element. Therefore, a differential voltage is created between the first and the second electrically conductive layer 13, 14, which depends on a temperature at the location of the VIA 18 (or rather at the location of the junction between the layers). The second electrically conductive layer 14 and the first electrically conductive layer 13 may then be contacted and connected to corresponding readout devices 19 (i.e., for example, sensor chips 19c, as shown in Fig. 5) via corresponding conductive tracks 23, as described herein. The optional n-th electrically conductive layers 15 may, for example, act as separate signaling or readout layers for contacting at least one of the first and the second electrically conductive tracks 13, 14.

Fig. 5 shows a possible connection scheme of an electrical interconnect board 10. The lay-up of the printed circuit board (PCB) 12 and the configuration of the receptacles/recesses 16 in the PCB 12 may be configured according to any one of the embodiments described with regard to Fig. 1 to 4 or otherwise described herein. The illustrated electrical interconnect board 10 is configured to connect a vertical line of battery cells 21 (as illustrated three battery cells each) in series. These serial connections of battery cells 21 are connected in parallel with each other by parallel connections 25, which may, for example, be busbars, which are part of the first electrically conductive layer 13. However, any other connection scheme is possible, too.

In Fig. 5, it is clearly visible, how the VIAs 18, and therefore the corresponding thermocouples, which are each associated with a specific receptacle 16 (and therefore with a specific battery cell 21, when in use) are connected with corresponding readout devices 19, such as sensor chips 19c, via corresponding conductive tracks 23, as described further above. In the illustrated example, each sensor chip 19c serves one horizontal line of receptacles 16 (or rather VIAs 18 of the receptacles 16). However, a single sensor chip 19c may also serve any other number of VIAs 18.

Fig. 6 shows a battery module 20 comprising a plurality of battery cells 21 and an electrical interconnect board 10, as described herein. The electrical interconnect board 10 may be configured according to any one of the embodiments described herein. The bottom part of Fig. 6 shows the top section of the battery module 20, and therefore the electrical interconnect board 10, enlarged. The contact elements 17 of the electrical interconnect board 10, may, for example, be laser welded to the electrodes of the battery cells 21. However, any other connection is conceivable, too.

In summary, the disclosed electrical interconnect board 10 provides the ability for single cell temperature measurement for battery modules 20 comprising a plurality of battery cells 21. The proposed solution avoids any wired or soldered sensor elements and therefore decreases weight, increases security by monitoring each cell temperature, and provides a versatile electrical interconnection. In particular, potentially dangerous situation, such as thermal runaway conditions of battery cells 21, can be detected very fast because the temperatures of each battery cell can be continuously monitored.

It should be noted that "comprising" or "including" does not exclude other elements or steps, and "one" or "a" does not exclude a plurality. It should further be noted that features or steps that have been described with reference to any of the above embodiments may also be used in combination with other features or steps of other embodiments described above. Reference signs in the claims are not to be regarded as limitation.

### LIST OF REFERENCE SIGNS

- 10: electrical interconnect board
- 11: printed circuit board (PCB)
- 12: insulating layer
- 13: first electrically conductive layer
- 14: second electrically conductive layer
- 15: n-th electrically conductive layer
- 16: receptacles, recesses
- 17: contact elements
- 17c: connection section (of contact element)
- 17s: sensor section (of contact element)
- 17p: positive contact element
- 17n: negative contact element
- 18: vertical interconnect access (VIA)
- 19: readout device
- 19c: sensor chip
- 20: battery module
- 21: battery cells
- 22: electrodes
- 22p: positive electrode
- 22n: negative electrode
- 23: conductive tracks
- 24: air gap, isolating material
- 25: parallel connections
- 30: reference temperature sensor

## Claims

1. Electrical interconnect board (10) with integrated cell temperature measurement for a battery module (20) having a plurality of battery cells (21), the electrical interconnect board (10) comprising a printed circuit board (11) and a readout device (19);
wherein the printed circuit board (11) comprises an insulating layer (12), a first electrically conductive layer (13), and a second electrically conductive layer (14);
wherein the first electrically conductive layer (13) and the second electrically conductive layer (14) are arranged on opposite sides of the insulating layer (12);
wherein the printed circuit board (11) comprises a plurality of receptacles (16) each configured for accommodating a corresponding battery cell (21) of the battery module (20);
wherein the first electrically conductive layer (13) is configured to electrically interconnect the plurality of battery cells (21) with each other;
wherein the first electrically conductive layer (13) and the second electrically conductive layer (14) are made from different electrically conductive materials;
wherein the first electrically conductive layer (13) and the second electrically conductive layer (14) are connected with each other through the insulating layer (12) at a plurality of locations by a plurality of vertical interconnect accesses (18), VIAs (18);
wherein each VIA (18) builds a thermoelectric interface and thereby forms an integrated thermal sensor element that generates a voltage depending on the temperature at the thermoelectric interface; and
wherein the readout device (19) senses the generated voltages of the VIAs (18) and determines corresponding temperature values.

2. Electrical interconnect board (10) of claim 1, wherein the plurality of receptacles (16) are corresponding recesses (16); and
wherein the first electrically conductive layer (13) protrudes into each of the plurality of recesses (16), thereby building contact elements (17) configured to contact electrodes (22) of a corresponding one of the battery cells (21), such that the battery cells (21) of the battery module (20) are electrically connected to each other to build an electrical circuit of battery cells (21).

3. Electrical interconnect board (10) of claim 1 or 2, wherein the first electrically conductive layer (13) is made from copper.

4. Electrical interconnect board (10) of any one of the preceding claims, wherein the second electrically conductive layer (14) is made from a copper-nickel alloy.

5. Electrical interconnect board (10) of claim 4, wherein the second electrically conductive layer (14) is made from constantan.

6. Electrical interconnect board (10) of any one of claims 2 to 5, wherein the location of each VIA (18) is located near a corresponding contact element (17) of an associated recess (16), such that the thermal sensor element formed by the corresponding VIA (18) measures a temperature near the location of the corresponding contact element (17).

7. Electrical interconnect board (10) of claim 6, wherein the corresponding contact element (17) is configured to conduct heat from an associated battery cell (21) to the corresponding VIA (17), such that the thermal sensor element formed by the corresponding VIA (18) indicates a temperature of the associated battery cell (21).

8. Electric interconnect board (10) of any one of claims 2 to 7, wherein the contact elements (17) of each recess (16) comprise a positive contact element (17p) configured to contact a positive electrode of the battery cell (21) and a negative contact element (17n) configured to contact a negative electrode of the battery cell (21).

9. Electric interconnect board (10) of claim 8, wherein at least one of the positive contact element (17p) and the negative contact element (17n) is split into a connection section (17c) and a sensor section (17s).

10. Electric interconnect board (10) of claim 9, wherein the sensor section (17s) and the connection section (17c) are electrically and/or thermally isolated from each other.

11. Electric interconnect board (10) of claim 10, wherein the connection section (17c) is configured for electrically connecting and thereby integrating the battery cell (21) into the electrical circuit of battery cells (21).

12. Electric interconnect board (10) of claim 10 or 11, wherein the sensor section (17s) is associated with a corresponding VIA (18) and configured to conduct thermal energy of the battery cell (21) to the corresponding VIA (18).

13. Electrical interconnect board (10) of any one of the preceding claims, wherein the readout device (19) comprises at least one sensor chip (19);
wherein a conductive track (23) of the first electrically conductive layer (13) and a conductive track (23) of the second electrically conductive layer (14) that are associated with a corresponding VIA (18) are connected to a corresponding one of the sensor chips (19), such that the corresponding sensor chip (19) is configured to measure a voltage between the corresponding conductive tracks (23) of the first electrically conductive layer (13) and of the second electrically conductive layer (14) and to determine a corresponding temperature value based on the measured voltage.

14. Electric interconnect board (10) of claim 13, further comprising at least one dedicated reference temperature sensor (30) arranged in the vicinity of the at least one sensor chip (19).

15. Battery module (20), comprising:
a plurality of battery cells (21); and
an electrical interconnect board (10) of any one of the preceding claims;
wherein each of the plurality of battery cells (21) is arranged within a corresponding one of the receptacles (16), such that the battery cells (21) are connected with each other to form a circuit of battery cells (21).

## Patentansprüche

1. Elektrische Verbindungsplatte (10) mit integrierter Zelltemperaturmessung für ein Batteriemodul (20) mit einer Vielzahl von Batteriezellen (21), wobei die elektrische Verbindungsplatte (10) eine gedruckte Leiterplatte (11) und eine Auslesevorrichtung (19) umfasst;
wobei die gedruckte Leiterplatte (11) eine Isolierschicht (12), eine erste elektrisch leitfähige Schicht (13) und eine zweite elektrisch leitfähige Schicht (14) umfasst;
wobei die erste elektrisch leitfähige Schicht (13) und die zweite elektrisch leitfähige Schicht (14) auf gegenüberliegenden Seiten der Isolierschicht (12) angeordnet sind;
wobei die gedruckte Leiterplatte (11) eine Vielzahl von Aufnahmen (16) umfasst, die jeweils zum Aufnehmen einer entsprechenden Batteriezelle (21) des Batteriemoduls (20) konfiguriert sind;
wobei die erste elektrisch leitfähige Schicht (13) konfiguriert ist, die Vielzahl von Batteriezellen (21) elektrisch miteinander zu verbinden;
wobei die erste elektrisch leitfähige Schicht (13) und die zweite elektrisch leitfähige Schicht (14) aus unterschiedlichen elektrisch leitfähigen Materialien hergestellt sind;
wobei die erste elektrisch leitfähige Schicht (13) und die zweite elektrisch leitfähige Schicht (14) durch die Isolierschicht (12) an einer Vielzahl von Stellen durch eine Vielzahl von vertikalen Durchkontaktierungen (18), VIAs (18), miteinander verbunden sind;
wobei jede VIA (18) eine thermoelektrische Schnittstelle bildet und dadurch ein integriertes thermisches Sensorelement bildet, das eine Spannung in Abhängigkeit von der Temperatur an der thermoelektrischen Schnittstelle erzeugt; und
wobei die Auslesevorrichtung (19) die erzeugten Spannungen der VIAs (18) erfasst und entsprechende Temperaturwerte bestimmt.

2. Elektrische Verbindungsplatte (10) nach Anspruch 1, wobei die Vielzahl von Aufnahmen (16) entsprechende Ausnehmungen (16) sind; und
wobei die erste elektrisch leitfähige Schicht (13) in jede der Vielzahl von Ausnehmungen (16) vorsteht, wodurch Kontaktelemente (17) gebildet werden, die konfiguriert sind, Elektroden (22) einer entsprechenden der Batteriezellen (21) zu kontaktieren, so dass die Batteriezellen (21) des Batteriemoduls (20) elektrisch miteinander verbunden sind, um eine elektrische Schaltung von Batteriezellen (21) zu bilden.

3. Elektrische Verbindungsplatte (10) nach Anspruch 1 oder 2, wobei die erste elektrisch leitfähige Schicht (13) aus Kupfer hergestellt ist.

4. Elektrische Verbindungsplatte (10) nach einem der vorhergehenden Ansprüche, wobei die zweite elektrisch leitfähige Schicht (14) aus einer Kupfer-Nickel-Legierung hergestellt ist.

5. Elektrische Verbindungsplatte (10) nach Anspruch 4, wobei die zweite elektrisch leitfähige Schicht (14) aus Konstantan hergestellt ist.

6. Elektrische Verbindungsplatte (10) nach einem der Ansprüche 2 bis 5, wobei sich die Position jeder VIA (18) in der Nähe eines entsprechenden Kontaktelements (17) einer zugehörigen Ausnehmung (16) befindet, so dass das durch die entsprechende VIA (18) gebildete thermische Sensorelement eine Temperatur in der Nähe der Position des entsprechenden Kontaktelements (17) misst.

7. Elektrische Verbindungsplatte (10) nach Anspruch 6, wobei das entsprechende Kontaktelement (17) konfiguriert ist, Wärme von einer zugehörigen Batteriezelle (21) zu der entsprechenden VIA (17) zu leiten, so dass das durch die entsprechende VIA (18) gebildete thermische Sensorelement eine Temperatur der zugehörigen Batteriezelle (21) anzeigt.

8. Elektrische Verbindungsplatte (10) nach einem der Ansprüche 2 bis 7, wobei die Kontaktelemente (17) jeder Ausnehmung (16) ein positives Kontaktelement (17p), das konfiguriert ist, eine positive Elektrode der Batteriezelle (21) zu kontaktieren, und ein negatives Kontaktelement (17n), das konfiguriert ist, eine negative Elektrode der Batteriezelle (21) zu kontaktieren, umfassen.

9. Elektrische Verbindungsplatte (10) nach Anspruch 8, wobei mindestens eines von dem positiven Kontaktelement (17p) und dem negativen Kontaktelement (17n) in einen Verbindungsabschnitt (17c) und einen Sensorabschnitt (17s) geteilt ist.

10. Elektrische Verbindungsplatte (10) nach Anspruch 9, wobei der Sensorabschnitt (17s) und der Verbindungsabschnitt (17c) elektrisch und/oder thermisch voneinander isoliert sind.

11. Elektrische Verbindungsplatte (10) nach Anspruch 10, wobei der Verbindungsabschnitt (17c) zum elektrischen Verbinden und dadurch Integrieren der Batteriezelle (21) in die elektrische Schaltung von Batteriezellen (21) konfiguriert ist.

12. Elektrische Verbindungsplatte (10) nach Anspruch 10 oder 11, wobei der Sensorabschnitt (17s) einer entsprechenden VIA (18) zugeordnet und konfiguriert ist, thermische Energie der Batteriezelle (21) zu der entsprechenden VIA (18) zu leiten.

13. Elektrische Verbindungsplatte (10) nach einem der vorhergehenden Ansprüche, wobei die Auslesevorrichtung (19) mindestens einen Sensorchip (19) umfasst;
wobei eine Leiterbahn (23) der ersten elektrisch leitfähigen Schicht (13) und eine Leiterbahn (23) der zweiten elektrisch leitfähigen Schicht (14), die einer entsprechenden VIA (18) zugeordnet sind, mit einem entsprechenden der Sensorchips (19) verbunden sind, so dass der entsprechende Sensorchip (19) konfiguriert ist, eine Spannung zwischen den entsprechenden Leiterbahnen (23) der ersten elektrisch leitfähigen Schicht (13) und der zweiten elektrisch leitfähigen Schicht (14) zu messen und einen entsprechenden Temperaturwert basierend auf der gemessenen Spannung zu bestimmen.

14. Elektrische Verbindungsplatte (10) nach Anspruch 13, ferner umfassend mindestens einen dedizierten Referenztemperatursensor (30), der in der Nähe des mindestens einen Sensorchips (19) angeordnet ist.

15. Batteriemodul (20), umfassend:
eine Vielzahl von Batteriezellen (21); und
eine elektrische Verbindungsplatte (10) nach einem der vorhergehenden Ansprüche;
wobei jede der Vielzahl von Batteriezellen (21) innerhalb einer entsprechenden der Aufnahmen (16) angeordnet ist, so dass die Batteriezellen (21) miteinander verbunden sind, um eine Schaltung von Batteriezellen (21) zu bilden.

## Revendications

1. Carte d'interconnexion électrique (10) avec une mesure de température de cellule intégrée pour un module de batterie (20) ayant une pluralité de cellules de batterie (21), la carte d'interconnexion électrique (10) comprenant une carte de circuit imprimé (11) et un dispositif de lecture (19);
dans laquelle la carte de circuit imprimé (11) comprend une couche isolante (12), une première couche électriquement conductrice (13), et une seconde couche électriquement conductrice (14);
dans laquelle la première couche électriquement conductrice (13) et la seconde couche électriquement conductrice (14) sont agencées sur des côtés opposés de la couche isolante (12);
dans laquelle la carte de circuit imprimé (11) comprend une pluralité de réceptacles (16) configurés chacun pour recevoir une cellule de batterie (21) correspondante du module de batterie (20);
dans laquelle la première couche électriquement conductrice (13) est configurée pour interconnecter électriquement la pluralité de cellules de batterie (21) entre eux;
dans laquelle la première couche électriquement conductrice (13) et la seconde couche électriquement conductrice (14) sont réalisées à partir de matériaux électriquement conducteurs différents;
dans laquelle la première couche électriquement conductrice (13) et la seconde couche électriquement conductrice (14) sont connectées entre elles par l'intermédiaire de la couche isolante (12) à une pluralité d'emplacements par une pluralité d'accès d'interconnexion verticaux (18), VIAs (18);
dans laquelle chaque VIA (18) construit une interface thermoélectrique et forme ainsi un élément de capteur thermique intégré qui génère une tension en fonction de la température au niveau de l'interface thermoélectrique; et
dans laquelle le dispositif de lecture (19) détecte les tensions générées des VIA (18) et détermine des valeurs de température correspondantes.

2. Carte d'interconnexion électrique (10) selon la revendication 1, dans laquelle la pluralité de réceptacles (16) sont des évidements correspondants (16); et
dans laquelle la première couche électriquement conductrice (13) fait saillie dans chacun de la pluralité d'évidements (16), construisant ainsi des éléments de contact (17) configurés pour contacter des électrodes (22) d'une cellule correspondante des cellules de batterie (21), de sorte que les cellules de batterie (21) du module de batterie (20) sont connectées électriquement les unes aux autres pour construire un circuit électrique de cellules de batterie (21).

3. Carte d'interconnexion électrique (10) selon la revendication 1 ou 2, dans laquelle la première couche électriquement conductrice (13) est réalisée à partir de cuivre.

4. Carte d'interconnexion électrique (10) selon l'une quelconque des revendications précédentes, dans laquelle la seconde couche électriquement conductrice (14) est réalisée à partir d'un alliage cuivre-nickel.

5. Carte d'interconnexion électrique (10) selon la revendication 4, dans laquelle la seconde couche électriquement conductrice (14) est réalisée à partir de constantan.

6. Carte d'interconnexion électrique (10) selon l'une quelconque des revendications 2 à 5, dans laquelle l'emplacement de chaque VIA (18) est situé à proximité d'un élément de contact (17) correspondant d'un évidement (16) associé, de sorte que l'élément de capteur thermique formé par le VIA (18) correspondant mesure une température à proximité de l'emplacement de l'élément de contact (17) correspondant.

7. Carte d'interconnexion électrique (10) selon la revendication 6, dans laquelle l'élément de contact (17) correspondant est configuré pour conduire la chaleur d'une cellule de batterie (21) associée au VIA (17) correspondant, de sorte que l'élément de capteur thermique formé par le VIA (18) correspondant indique une température de la cellule de batterie (21) associée.

8. Carte d'interconnexion électrique (10) selon l'une quelconque des revendications 2 à 7, dans laquelle les éléments de contact (17) de chaque évidement (16) comprennent un élément de contact positif (17p) configuré pour contacter une électrode positive de la cellule de batterie (21) et un élément de contact négatif (17n) configuré pour contacter une électrode négative de la cellule de batterie (21).

9. Carte d'interconnexion électrique (10) selon la revendication 8, dans laquelle au moins l'un de l'élément de contact positif (17p) et de l'élément de contact négatif (17n) est divisé en une section de connexion (17c) et une section de capteur (17s).

10. Carte d'interconnexion électrique (10) selon la revendication 9, dans laquelle la section de capteur (17s) et la section de connexion (17c) sont électriquement et/ou thermiquement isolées l'une de l'autre.

11. Carte d'interconnexion électrique (10) selon la revendication 10, dans laquelle la section de connexion (17c) est configurée pour connecter électriquement et intégrer ainsi la cellule de batterie (21) dans le circuit électrique de cellules de batterie (21).

12. Carte d'interconnexion électrique (10) selon la revendication 10 ou 11, dans laquelle la section de capteur (17s) est associée à un VIA (18) correspondant et configurée pour conduire l'énergie thermique de la cellule de batterie (21) au VIA (18) correspondant.

13. Carte d'interconnexion électrique (10) selon l'une quelconque des revendications précédentes, dans laquelle le dispositif de lecture (19) comprend au moins une puce de capteur (19);
dans laquelle une piste conductrice (23) de la première couche électriquement conductrice (13) et une piste conductrice (23) de la seconde couche électriquement conductrice (14) qui sont associées à un VIA (18) correspondant sont connectées à une puce correspondante des puces de capteur (19), de sorte que la puce de capteur (19) correspondante est configurée pour mesurer une tension entre les pistes conductrices (23) correspondantes de la première couche électriquement conductrice (13) et de la seconde couche électriquement conductrice (14) et pour déterminer une valeur de température correspondante sur la base de la tension mesurée.

14. Carte d'interconnexion électrique (10) selon la revendication 13, comprenant en outre au moins un capteur de température de référence dédié (30) agencé à proximité de l'au moins une puce de capteur (19).

15. Module de batterie (20), comprenant :
une pluralité de cellules de batterie (21) ; et
une carte d'interconnexion électrique (10) selon l'une quelconque des revendications précédentes;
dans lequel chacune de la pluralité de cellules de batterie (21) est agencée à l'intérieur d'un réceptacle correspondant des réceptacles (16), de sorte que les cellules de batterie (21) sont connectées les unes aux autres pour former un circuit de cellules de batterie (21).
